# EUROPEAN PATENT SPECIFICATION

(11) **EP 2 850 032 B1**
(45) Date of publication and mention of the grant of the patent: **04.05.2022**
(21) Application number: 13790486.8
(22) Date of filing: 17.05.2013
(51) Int. Cl.: C01B 32/186, B82Y 40/00, C30B 25/00, B82Y 30/00, C23C 16/26, C23C 16/455, C23C 16/56

(54) **METHODS OF GROWING UNIFORM, LARGE-SCALE, MULTILAYER GRAPHENE FILMS**
VERFAHREN ZUM ZÜCHTEN VON GLEICHMÄSSIGEN, GROSSFLÄCHIGEN, MEHRSCHICHTIGEN GRAPHENFILMEN
PROCÉDÉS POUR FAIRE CROÎTRE DES FILMS DE GRAPHÈNE MULTICOUCHES UNIFORMES, À GRANDE ÉCHELLE

(30) Priority: 17.05.2012 US 201261648328 P
(43) Date of publication of application: 25.03.2015
(73) Proprietor: National University of Singapore, Singapore 119077 (SG)
(72) Inventor: LOH, Kian Ping, Singapore 119077 (SG); ZHANG, Kai, Singapore 119077 (SG); CASTRO NETO, Antonio Helio, Singapore 119077 (SG)
(74) Representative: Docherty, Robert Charles
(86) International application number: PCT/SG2013/000202
(87) International publication number: WO 2013/172792

(56) References cited:
- WO-A1-2012/172338
- US-A1- 20110 014 368
- ZHANCHENG LI ET AL: "Low-Temperature Growth of Graphene by Chemical Vapor Deposition Using Solid and Liquid Carbon Sources", ACS NANO, vol. 5, no. 4, 26 April 2011 (2011-04-26), pages 3385-3390, XP055100300, ISSN: 1936-0851, DOI: 10.1021/nn200854p
- TAKEO YAMADA ET AL: "Revealing the Secret of Water-Assisted Carbon Nanotube Synthesis by Microscopic Observation of the Interaction of Water on the Catalysts", NANO LETTERS, vol. 8, no. 12, 10 December 2008 (2008-12-10), pages 4288-4292, XP055192336, ISSN: 1530-6984, DOI: 10.1021/nl801981m
- ABDELADIM GUERMOUNE ET AL: "Chemical vapor deposition synthesis of graphene on copper with methanol, ethanol, and propanol precursors", CARBON, ELSEVIER, OXFORD, GB, vol. 49, no. 13, 28 May 2011 (2011-05-28), pages 4204-4210, XP028255228, ISSN: 0008-6223, DOI: 10.1016/J.CARBON.2011.05.054 [retrieved on 2011-06-01]
- G.ABDELADIN ET AL.: 'CHEMICAL VAPOUR DEPOSITION SYNTHESIS OF GRAPHENE ON COPPER WITH METHANOL, ETHANOL AND PROPANOL PRECURSORS' CARBON vol. 49, 2011, pages 4204 - 4210, XP028255228
- C. MATTEVI: 'A REVIEW OF CHEMICAL VAPOUR DEPOSITION OF GRAPHENE ON COPPER' JOURNAL OF MATERIALS CHEMISTRY vol. 21, 2011, pages 3324 - 3334, XP055128831
- LI XUESONG ET AL.: 'LARGE-AREA SYNTHESIS OF HIGH QUALITY AND UNIFORM GRAPHENE FILMS ON COPPER FOILS.SUPPORTING ONLINE MATERIAL CAN BE FOUND AT: HTTP://WWW.SCIENCEMAG.ORG/CGI/CONTENT/FULL/ 1171245/DC1 WHOLE DOCUMENT;FIGURE 2(C);1313 RHC' SCIENCE no. 324, 2009, pages 1312 - 1314, XP008127472
- MUELLER: 'GROWING GRAPHENE ON POLYCRYSTALLINE COPPER FOILS BY ULTRA-HIGH VACUUM CHEMICAL VAPOR DEPOSITION' THESIS: POLLARD May 2011, DEPARTMENT OF PHYSICS, POMONA COLLEGE, pages 23 - 30, XP029043381
- SOO KIM KEUN: 'LARGE-SCALE PATTERN GROWTH OF GRAPHENE FILMS FOR STRETCHABLE TRANSPARENT ELECTRODES' NATURE no. 457, 05 February 2009, pages 706 - 710, XP008127462 DOI: 10.1038/NATURC07719
- I. VLASSIOUK ET AL.: 'ROLE OF HYDROGEN IN CHEMICAL VAPOUR DEPOSITION GROWTH OF LARGE SINGLE-CRYSTAL GRAPHENE' ACS NANO vol. 5, no. 7, 2011, pages 6069 - 6076, XP055078407

## Description

### FIELD

This disclosure relates generally to methods of producing graphene and in particular to methods of growing substantially uniform, large-scale, multilayer graphene films.

### BACKGROUND ART

Graphene is a one-atom-thick allotrope of carbon and has attracted attention due to its unique band structure and its structural, electrical and optical properties. Prototype devices incorporated with graphene, such as high-frequency field-effect transistors (FETs), photo-voltaic systems (solar cells), chemical sensors, super-capacitors, etc., have demonstrated the potential for the application of graphene in future electronics and optoelectronics devices. An overview of graphene is set forth in the article by A. K. Geim and K. S. Novoselov, entitled "The rise of graphene," Nature Materials 6, no. 3 (2007): 183-191.

To satisfy the widespread applications of graphene and the anticipated commercial demand for graphene-based products, it is critical to develop high-throughput and high-quality methods for producing large-area, wafer-size graphene samples. Various methods for graphene synthesis have already been proposed. Some of these methods include mechanical cleavage of Highly Oriented Pyrolytic Graphite (HOPG), ultra-high vacuum (UHV) annealing of single-crystal silicon carbide (SiC), chemical reduction of exfoliated graphite-oxide layers in liquid suspension, and chemical vapor deposition (CVD) on metals. For example, process for growing graphene by CVD is disclosed in the following: Li, Z et al (2011). Low -Temperature Growth of Graphene by Chemical Vapor Deposition Using Solid and Liquid Carbon Sources. ACS Nano, 5(4), pp. 3385-3390; and Guermoune, A et al (2011). Chemical vapor deposition synthesis of graphene on copper with methanol, ethanol, and propanol precursors. Carbon, 49, pp. 4204-210. However, neither process uses a weak oxidizing vapor during the growth of graphene.

An enhanced process for forming single walled carbon nanotubes (SWNTs) by chemical vapor deposition, in which water is added to reactivate catalysts inactivated by carbon coating, is disclosed in Yamada, T et al (2008). Revealing the Secret of Water-Assisted Carbon Nanotube Synthesis by Microscopic Observation of the Interaction of Water on the Catalysts. Nano Letters, 8(12), pp. 4288-4292. However, this document does not relate to the synthesis of multilayered graphene sheets.

Cleavage or exfoliation of graphite can produce only small-area graphene films on the order of tens to hundreds of micrometers and is clearly not industrially scalable. Obtaining graphene oxide through the chemical reduction of exfoliated graphite-oxide layers is limited by the material's poor electrical and structural properties. Thermal annealing of SiC at high temperatures (above 1,600°C) in UHV environment can be used to obtain large-area, high-quality graphene films. However, the separating and transferring of the graphene from the matrix to a substrate is still a challenging problem because graphene is unstable when subjected to random shear forces. Furthermore, the high cost of SiC substrates and the UHV conditions necessary for growth significantly limit the use of this method for industrial-scale graphene production.

Among the aforementioned techniques, the one involving CVD growth on transition metals appears the most promising since it allows for large-area synthesis and easy transfer of the graphene to practical substrates (such as glass or SiO₂). More importantly, the CVD process is compatible with high-volume CMOS-based technologies.

Recently, a graphene-formation method utilizing low-pressure CVD with copper as a catalyst has received attention because it enables large-area monolayer synthesis. The low solubility of carbon in copper renders the growth of graphene self-limited and restricted to a monolayer. However, CVD graphene growth on copper has chiefly focused on monolayer films formed under vacuum conditions. Moreover, graphene synthesized by this method does not have high electronic mobility and conductivity, with these values usually being about ten times smaller than for pristine graphene exfoliated from HOPG. The reduced quality is due to the presence of a large number of defects, such as domain and grain boundaries and wrinkles.

One way to overcome the low-conductivity limitation is by growing films of high-quality, stacked, multilayer graphene. Few-layer graphene grown by atmospheric-pressure chemical vapor deposition (AP-CVD) using various transition metals, including nickel, copper, ruthenium and cobalt, have been reported in the literature. However, films obtained by this method are non-uniform in thickness and have a low degree of crystallinity. In fact, the method leads to a film thickness that can vary from a few layers to hundreds of layers. Moreover, the low crystallinity usually yields high electrical resistance, while the non-uniformity in thickness results in low optical transmittance. Hence, multilayer graphene films made by conventional AP-CVD are tremendously limited in their technological application.

### SUMMARY

The present invention is as set out in the accompanying claims.

The invention provides a method for growing a graphene film. The method includes disposing a carbonizing catalyst having a surface in a chemical-vapor-deposition (CVD) reaction chamber having a pressure in a range from 133 mPa (1 mtorr) to 101 Pa (760 torr) and a temperature in a range from 200°C to 1,200°C. The method also includes flowing a gaseous carbon source and a weak oxidizing vapor over the surface of the carbonizing catalyst, where the carbon source is dissociated by either thermal or plasma activation, thereby causing carbon atoms from the carbon source to deposit in a crystalized carbon-atom arrangement on the surface of the carbonizing catalyst. The method further includes cooling the carbonizing catalyst and the crystalized carbon-atom arrangement to form a multilayer graphene film on the surface of the carbonizing catalyst.

The methods of growing graphene as disclosed herein can produce uniform, high-quality, large-scale multilayer graphene films. The methods comprise using a weak oxidizing vapor to assist the chemical vapor deposition of graphene on a carbonizing catalyst to form a uniform multilayer stack of graphene films. Aspects of the disclosed methods of growing graphene as disclosed herein produce a substantially uniform multilayer film of high-crystallinity graphene on the carbonizing catalyst.

The above-described problems of the prior-art methods of graphene synthesis are largely overcome in the present methods by using a weak oxidizing vapor incorporated in the chemical-vapor-deposition process. An aspect of the method removes amorphous carbon from the surface of the carbonizing catalyst, thereby enhancing the activity of the catalyst to form high-quality multilayer graphene films. Hence, the growth of multilayer graphene films with high quality can be effectively implemented. These and other features, aspects, and advantages of the disclosed embodiments will become better understood with reference to the description and embodiments presented below.

The methods described herein can effectively improve the efficiency of the catalyst and crystallinity of graphene films. Hence, the methods yield substantially uniform, high-quality, large-scale multilayer graphene films. The methods differ from the prior-art low-pressure, chemical-vapor-deposition method where the graphene growth on copper foil is self-limited and forms only single-layer graphene.

On the other hand, the multilayer graphene film formed using the methods disclosed herein has high crystallinity and a substantially uniform thickness over the entire area. The multilayer graphene film produced is superior to the conventional atmospheric chemical-vapor-deposition method with transition metals wherein the film has a large number of defects and large thickness variations (from a few layers to hundreds of layers of graphene). The good crystallinity of the film obtained using the methods disclosed herein helps to further improve the sheet resistance. Meanwhile, the substantially uniform thickness allows for very good optical properties, particularly optical transmittance.

The resulting multilayer graphene film made using the method disclosed herein can be used in various applications. For example, the enhanced electrical properties together with good optical transmittance of the multilayer graphene film, grown according to the present methods, can be used to form a flexible transparent electrode. The multilayer graphene film can also serve as a good substitute for traditional transparent conductive electrodes, such as indium tin oxide (ITO). It can be also used as an ultrathin electrode for lithium-ion batteries, in super-capacitors, as interconnects of integrated circuits, as active layers for photo-detectors, as planar optical polarizers, in biosensors, and in like devices.

The methods presented herein can be adjusted to obtain a controllable number of graphene layers, e.g., generally uniform, high-quality, large-scale bi-layer or tri-layer graphene films. As expected, shortening the growth time, decreasing the concentration of the carbonizing catalyst used as the precipitation source, adjusting the ratio of hydrogen to methane during the synthesis, and like adjustments (or combinations of adjustments) can be employed to obtain thinner graphene films (i.e., films with fewer graphene layers).

The electrical properties of the multilayer graphene as produced using the methods described herein can be further enhanced by chemical doping. It has been reported that up to an 80% decrease of sheet resistance with little sacrifice in transmittance can be realized by carefully controlling graphene doping, e.g., with nitric acid or AuCl₃.

Additional features and advantages of the disclosure will be set forth in the Detailed Description that follows, and in part will be readily apparent to those skilled in the art from that description or recognized by practicing the disclosure as described herein, including the detailed description that follows, the claims, and the appended drawings.

It is to be understood that both the foregoing general description and the following Detailed Description present embodiments of the disclosure and are intended to provide an overview or framework for understanding the nature and character of the disclosure as it is claimed. The accompanying drawings are included to provide a further understanding of the disclosure and are incorporated into and constitute a part of this specification.

The drawings illustrate various embodiments of the disclosure and together with the description serve to explain the principles and operations of the disclosure.

The claims as set forth below are incorporated into and constitute a part of the Detailed Description as presented below.

### BRIEF DESCRIPTION OF THE DRAWINGS

FIG. 1 is a schematic diagram of an example CVD reaction chamber and illustrates the growth of a multilayer graphene film according to the methods disclosed herein;
FIGS. 2A and 2B are schematic illustrations of a graphene film being placed onto and supported by the surface of a substrate;
FIGS. 3A through 3F illustrate an example embodiment of striping the graphene film from the carbonizing (graphene) catalyst using a protective layer, then supporting the graphene film and protective layer on a substrate, and then removing the protective layer;
FIG. 4A is a photographic image of two examples of a multilayer graphene film transferred onto and supported by a SiO₂/Si substrate;
FIG. 4B is an optical image of a multilayer graphene film on a SiO_{2/}Si substrate;
FIGS. 5A and 5B are an atomic-force microscopy image and a line-scan profile plot, respectively, of a multilayer graphene film on a SiO₂/Si substrate, wherein the thickness of the multilayer graphene film is about 4.2 nanometers (nm);
FIG. 6 is a Raman spectra of an example multilayer graphene film prepared according to the methods disclosed herein (spectrum a) and as compared to graphene films synthesized by conventional atmospheric-pressure chemical vapor deposition (spectrum b) and low-pressure chemical vapor deposition (spectrum c);
FIGS. 7A through 7D are transmission-electron-microscopy (TEM) images of an example multilayer graphene film prepared according to the methods disclosed herein, showing the high-quality crystallinity and the layer number (5 to ^{~}10 layers) of the film;
FIG. 8 is a plot of the optical transmittance (%) versus wavelength (nm) of a multilayer graphene film on glass, prepared according to methods disclosed herein (curve a) and as compared to graphene films synthesized by conventional atmospheric-pressure chemical vapor deposition (curve b) and low-pressure chemical vapor deposition (curve c); and
FIG. 9 is a bar chart that compares the electrical resistivity (sheet resistance in Ohms/square) of a multilayer graphene film prepared according to the embodiment of the present invention (bar a) and as compared to the graphene films synthesized by conventional atmospheric-pressure chemical vapor deposition (bar b) and low-pressure chemical vapor deposition (bar c).

### DETAILED DESCRIPTION

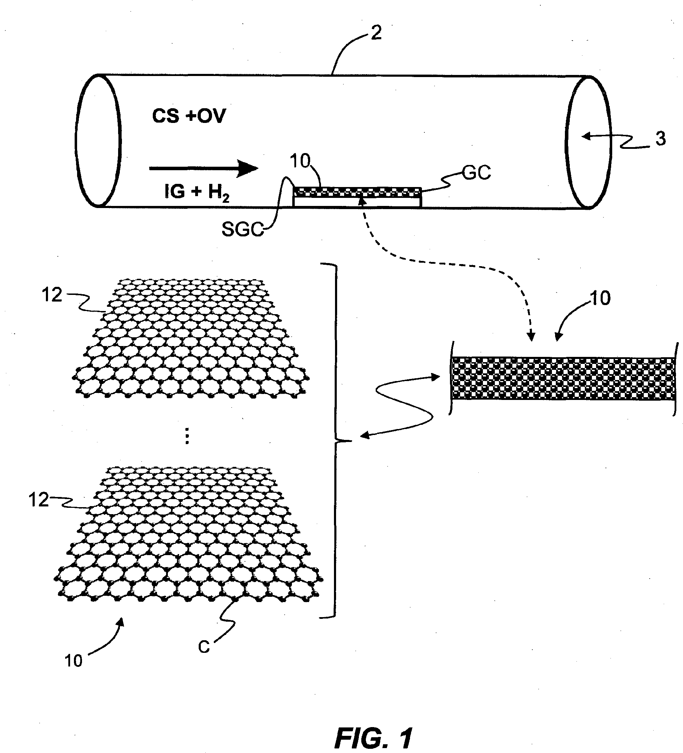

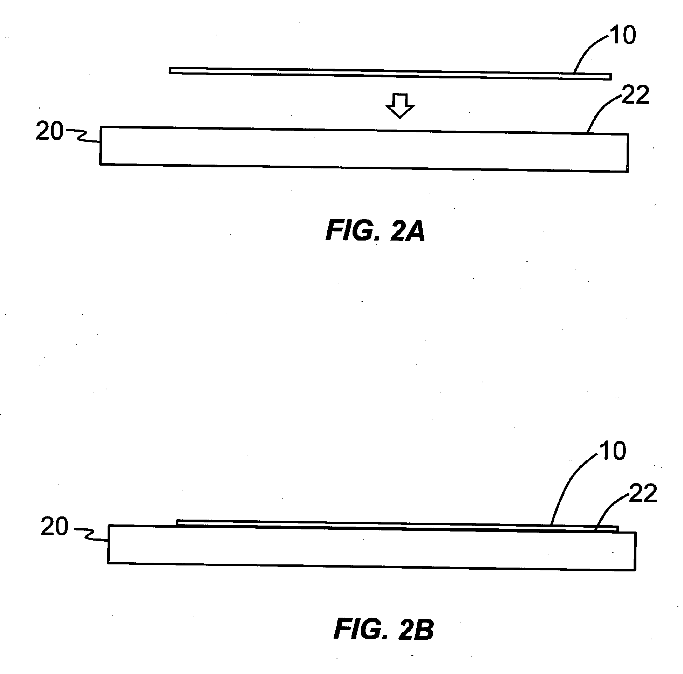

The multilayer graphene film may be formed according to the method illustrated in the schematic diagram of FIG. 1. FIGS. 2A and 2B illustrate an example of a graphene film 10 being placed on a surface 22 of a substrate 20, as described in greater detail below.

FIG. 1 shows a chemical-vapor-deposition (CVD) reaction chamber 2 that has an interior 3 that can be brought to a select high temperature and a select pressure to carry out the methods disclosed herein. In the disclosed methods, graphene film 10 is made up of one or more layers (sheets) of graphene 12, as shown in the close-up views, which shows the carbon atoms C in the characteristic hexagonal arrangement for graphene. The graphene film 10 is grown by CVD in CVD reaction chamber 2 using a gaseous carbon source CS and a weak oxidizing vapor (oxidizer) OV. The graphene film 10 made from multiple stacked individual sheets of graphene 12 can be formed by heat-treating gaseous carbon source CS in the presence of a graphitizing (carbonizing) catalyst GC having a surface SGC, while supplying an appropriate amount of oxidizing vapor OV. In the growing process, the dissociation of gaseous carbon source CS can be accomplished by either thermal or plasma activation.

When gaseous carbon source CS, together with oxidizing vapor OV, is heat-treated, at a selected temperature, for a selected period of time, and at an appropriate pressure, in CVD reaction-chamber interior 3 in the presence of graphitizing (carbonizing) catalyst GC and is thereafter cooled at a selected rate, graphene film 10 made up of one or more uniform, stacked layers of graphene 12 can be obtained.

The gaseous carbon source CS used in the formation of the graphene film 10 can be any substance, in any compound, that comprises carbon. In an example, the gaseous carbon source CS has a temperature of 200°C or higher. Example gaseous carbon sources CS include, but are not limited to, carbon monoxide, methane, ethane, ethylene, ethanol, acetylene, propane, propylene, butane, butadiene, pentane, pentene, cyclopentadiene, hexane, cyclohexane, benzene, toluene or a combination comprising at least one of the above-mentioned compounds.

The oxidizing vapor OV is an agent capable of appropriately reducing and preferably eliminating the amorphous carbon on the surface SGC of the carbonizing catalyst GC and enhancing the activity of the catalyst during the high-temperature heat-treating process. In an exemplary embodiment, water vapor, brought into the synthesis chamber by a separate H₂ flow through a bubbler, is utilized as the weak oxidizing vapor OV. In the invention, the oxidizing vapor OV is selected from water vapor and ethanol.

In an example, the graphitizing (carbonizing) catalyst GC may include a metal catalyst in the form of a thin or a thick film. The thin film of carbonizing catalyst GC may have a thickness between 300 nanometers ("nm") and 1,000 nm. A thick film of carbonizing catalyst GC may have a thickness between 0.01 millimeter ("mm") and 5 mm. Examples of a carbonizing catalyst GC may include at least one metal selected from the following group of metals: Ni, Cu, Co, Fe, Rh, Pt, Au, Ru and Mo.

The heat-treating process, sometimes accompanied by plasma assistance, is carried out in CVD reaction chamber 2 at a pressure varying from 133 mPa (1 mtorr) to 101 Pa (760 torr). The synthesis (growth) temperature can vary from 200°C to 1,200°C, and from a period of time varying from 1 min to 1 hour. During the synthesis, the gaseous carbon source CS is supplied at a flow rate from 0.5 standard cubic centimeters per minute ("sccm") to 50 sccm, with the oxidizing vapor OV at an amount of 1% to 10% by volume in the presence of an inert gas IG such as helium, argon or the like. In addition, hydrogen can be supplied to interior 3 of CVD reaction chamber 2 by the gaseous carbon source CS to reduce the carbonizing catalyst GC at the high-temperature annealing process before the synthesis and control of the gaseous reactions during the growth.

After the heat-treatment step that deposits carbon atoms onto the surface SGC of carbonizing catalyst GC, a controlled cooling process is performed to obtain a uniform arrangement of the carbon atoms that form stacked layers of graphene 12, wherein the stacked layers define graphene film 10. The cooling rate is from 0.1°C per minute to 10°C per minute. The graphene film 10 obtained after the cooling can be a substantially uniform multilayer over a large scale (e.g., a continuous surface area of at least about 1 cm²); in an exemplary embodiment graphene film 10 has between 2 and 20 layers of graphene 12, and in a more specific embodiment the graphene film has about 10 layers (i.e., 10 layers give or take a layer).

The synthesized, multilayer graphene film 10 can be separated from the carbonizing catalyst GC and cut into the desired size and shape. With reference to FIGS. 2A and 2B, the separated graphene film 10 can then be placed onto surface 22 of a suitable substrate 20. Substrates 20 can be materials selected from semiconductors, insulators, conductors and any combination thereof, including, for example, but not limited to: silicon, SiO₂-coated silicon, glass, polyethylene terephthalate ("PET"), metal and the like .

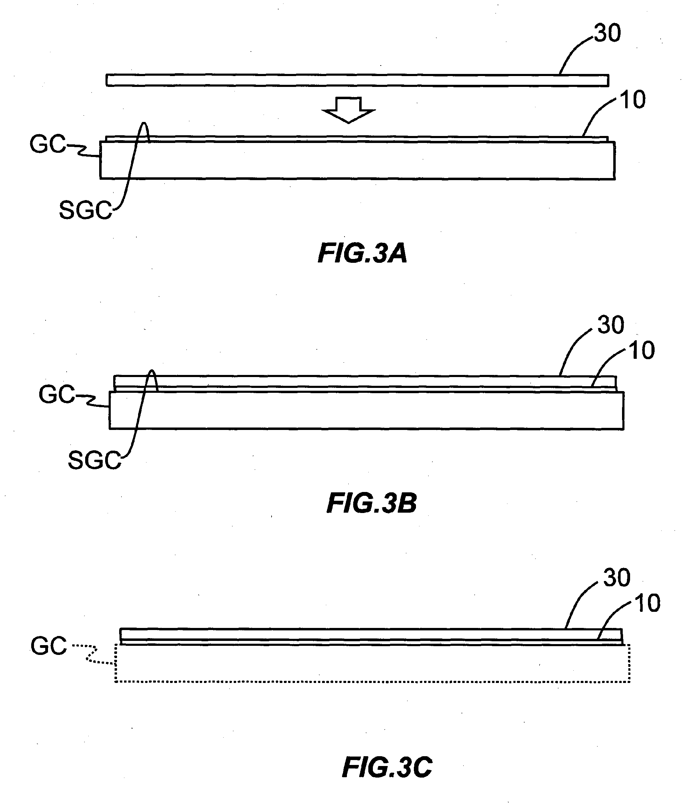

An exemplary embodiment of transferring the graphene film 10 onto surface 22 of substrate 20 is illustrated in FIGS. 3A-3F wherein the graphene film on the carbonizing catalyst GC is provided with a protective layer 30 (FIGS. 3A, 3B). In an example, the protective layer 30 is formed by spin coating. An example material for the protective layer 30 is polymethylmethacrylate (PMMA). With reference to FIG. 3C, the graphene film 10 is then separated from the carbonizing catalyst GC by an etching process that etches away the underlying carbonizing catalyst. The etching process can be carried out using conventional etching techniques, such as by using aqueous iron chloride or ammonia-persulfate solution.

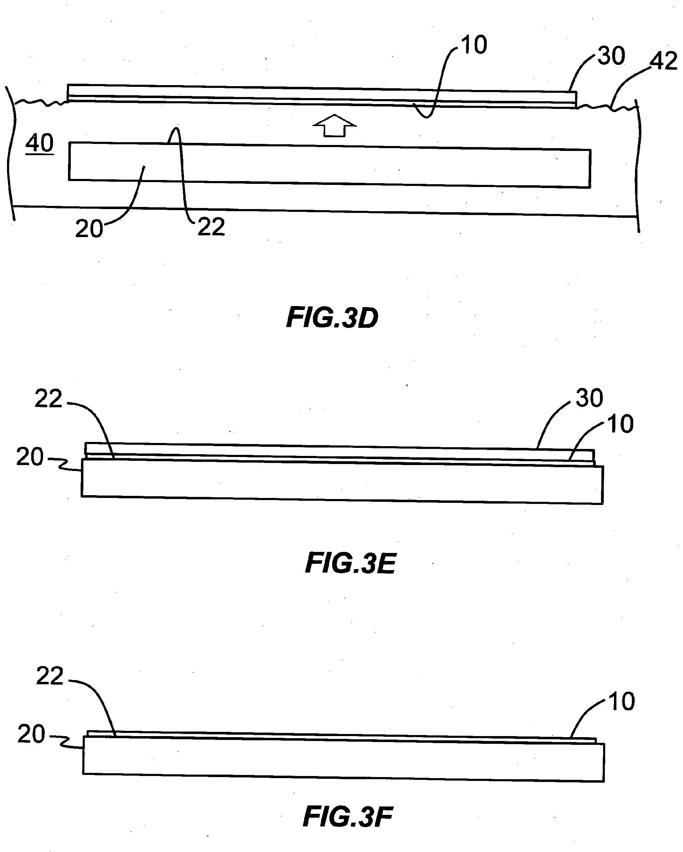

With reference to FIGS. 3D and 3E, after thoroughly rinsing the PMMA film 30 with graphene film 10 using deionized (DI) water (e.g., in a DI water bath 40 with water surface 42), substrate 20 is used to pick up the combined graphene film 10 and PMMA film 30 from the water surface. At this point, the protective PMMA layer can be removed (FIG. 3F) by either acetone or high temperature annealing with H₂ flow, leaving only the target multilayer graphene film 10 on the substrate 20.

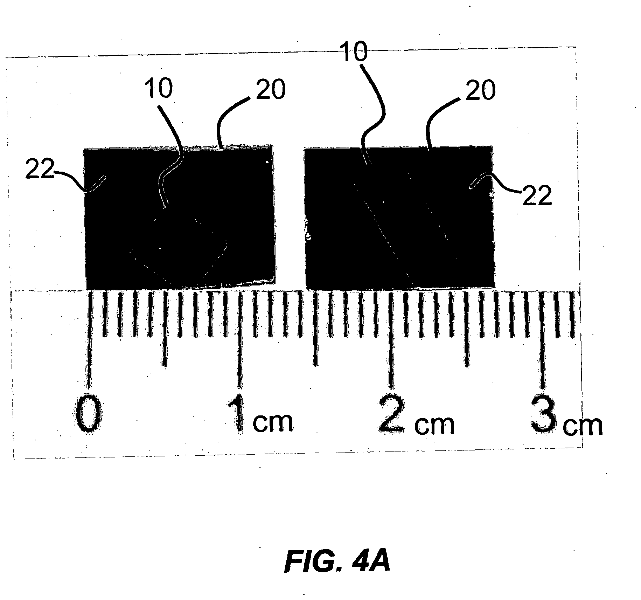

FIG. 4A shows a photographic image of two synthesized multilayer graphene films 10 transferred onto respective Si substrates 20 with a 280 nm-thick SiO₂ coating layer. The multilayer graphene films 10 are relatively large, as indicated by the accompanying ruler scale. Generally, the multilayer graphene films 10 can be formed to be of any reasonable size consistent with the apparatus being used to grow them.

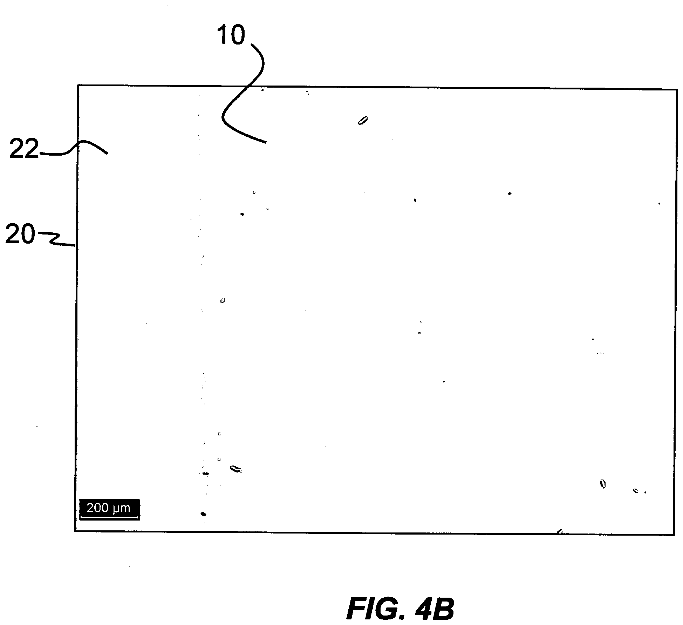

FIG. 4B is an optical image of an example multilayer graphene film 10 as formed as described above and transferred onto SiO₂/Si substrate 20. FIG. 4B shows that the synthesized graphene film 10 is continuous over a large area. Based on the uniformity of the optical contrast under the optical microscope, it was observed that the multilayer graphene film 10 obtained is relatively (substantially) uniform and has small thickness variations over the whole field. The optical contrast occurs due to the light interference between the SiO₂ substrate 20 and the graphene film 10.

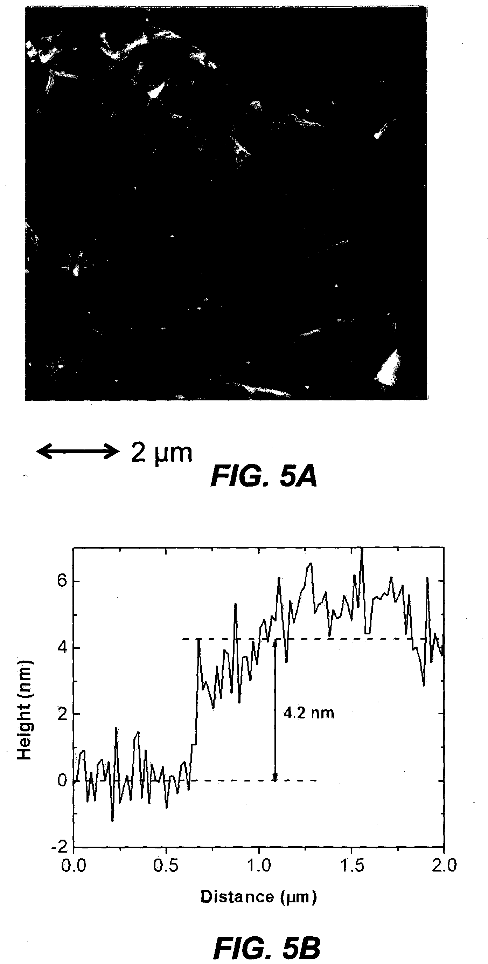

The thickness of the graphene film 10 can be directly measured by an atomic force microscope (AFM). FIG. 5A is an AFM image of an example multilayer graphene film 10 as formed on a SiO₂/Si substrate 20 using the methods disclosed herein. FIG. 5B is a line-scan profile plot of the multilayer graphene film 10 of FIG. 5A. The graphene film 10 has a height step of about 4.2 nm, suggesting the presence of multilayer layers of graphene 12, since the thickness of a monolayer of graphene is approximately 0.6 nm to 1 nm under AFM characterization. The thickness of 4.2 nm corresponds to approximately 10 layers of graphene 12, assuming 1 nm as the height for the first graphene layer and 0.35 nm for each subsequent graphene layer.

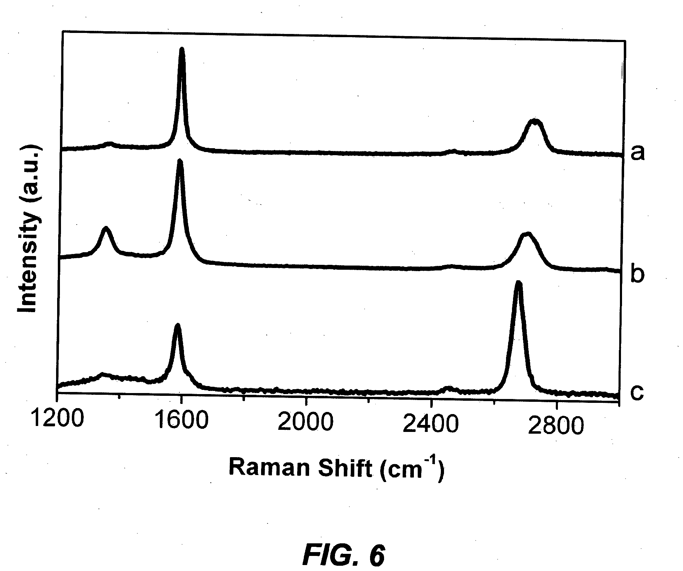

The number of layers of graphene 12 and the quality of the multilayer graphene film 10 can be identified using Raman spectroscopy. FIG. 6 is the Raman spectra of the multilayer graphene film 10 as formed using the methods disclosed herein (spectrum a) and as compared to graphene films grown by conventional AP-CVD and LP-CVD (spectra b and c, respectively). The peak-intensity ratio of the G to the 2D transitions is a good way to judge the number of graphene layers. The peak ratio of G to 2D transitions is > 3 for the graphene film 10 grown by the method disclosed herein as compared to < 0.5 for the monolayer graphene grown by LP-CVD, which further confirms that the film obtained is a multilayer film of graphene 12. The blue shift and the broader linewidth of the 2D band of the synthesized graphene film 10 also indicate the specialness of the multilayer graphene film. The low intensity of the disordered-induced D band (^{~}1350 cm⁻¹) is also observed in the graphene film 10 grown by the present methods, suggesting a high-quality film with a lower number of defects when compared with films prepared by AP-CVD.

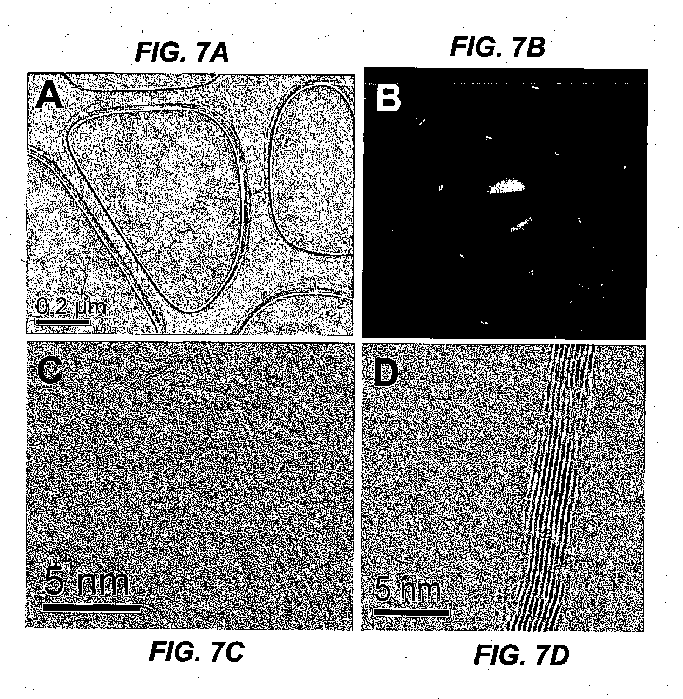

FIGS. 7A through 7D show transmission-electron-microscopy (TEM) images of the multilayer graphene film 10 grown using the methods disclosed herein. In FIG. 7A, one can see the multilayer graphene film 10 transferred onto a Quantifoil holey carbon grid under the low-magnification TEM image. Selected-area diffraction (SAD) on the film region within FIG. 7A reveals the distinctive hexagonal lattice structure of the multilayer graphene film 10, as shown in FIG. 7B. This indicates its good crystallinity. High resolution TEM (HRTEM) imaging of the film edge provides a direct proof of the number of layers of the multilayer graphene 12. Using these HRTEM edge images, as shown in FIG. 7C and FIG. 7D, to count from, the multilayer graphene film prepared by the inventive method is usually about five to about ten layers thick. These TEM characterizations reveal the single-crystal nature of the examined areas, indicating the high quality of the synthesized multilayer graphene films 10.

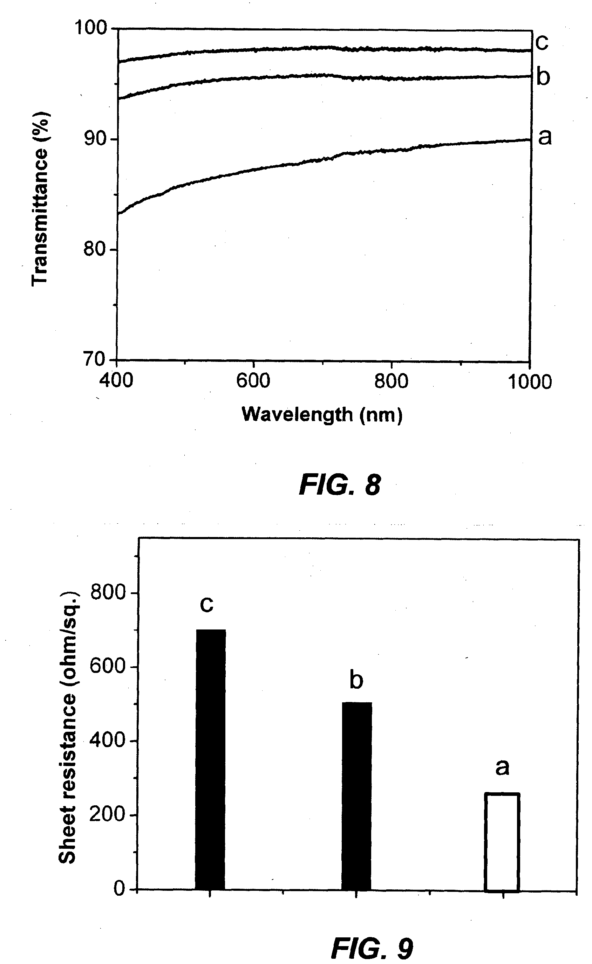

The optical and electrical properties of the multilayer graphene film 10 grown using the methods disclosed herein can be examined through its optical-transmittance and electrical-resistance characteristics. The optical transmittance was measured with a UV-VIS spectrophotometer after transferring the graphene film 10 onto a glass substrate 20, and the results are presented in the plot of FIG. 8, with curve a corresponding to the methods disclosed herein, curve b corresponding to AP-CVD and curve c corresponding to LP-CVD. The results show an optical transmittance of 86.7% for the multilayer graphene film 10 at the wavelength of 550 nm. This compares to the measured 95.4% transmittance of a graphene film 10 grown by conventional AP-CVD and 98% of the monolayer graphene grown by LP-CVD. The sheet-resistance measurement of the synthesized multilayer graphene film 10 was taken by a four-point probe technique after the transference of the graphene film onto a SiO₂/Si substrate 20.

FIG. 9 is a bar chart that compares the electrical resistivity (sheet resistance in Ohms/square) of a multilayer graphene film prepared according to the embodiment of the present invention (bar a) and as compared to the graphene films synthesized by conventional atmospheric-pressure chemical vapor deposition (bar b) and low-pressure chemical vapor deposition (bar c). Bar a shows a measured electrical resistance of approximately 200 Ω/sq.

The results show great improvement relative to the monolayer graphene 12 synthesized by LP-CVD. It is worth noting that the sheet resistance of the multilayer graphene film 10 of the present method is less than half of that grown by conventional AP-CVD. Compared to that of the LP-CVD monolayer graphene, the electrical resistance is improved with the stacking of graphene layers and is similar to the case of layer-by-layer transferring. On the other hand, the lower electrical resistance of the multilayer graphene film 10 according to the present embodiment indicates the high crystal quality relative to that achieved using the conventional AP-CVD method.

## Claims

1. A method for growing a graphene film, comprising:
disposing a carbonizing catalyst having a surface in a chemical-vapor-deposition (CVD) reaction chamber having a pressure in a range from 133 mPa (1 mtorr) to 101 Pa (760 torr), and a temperature in a range from 200°C to 1,200°C;
flowing a gaseous carbon source having carbon atoms, and a weak oxidizing vapor over the surface of the carbonizing catalyst for a time in the range from 1 minute to 1 hour, thereby causing the carbon atoms from the carbon source to deposit in a crystalized carbon-atom arrangement on the surface of the carbonizing catalyst; and
cooling the carbonizing catalyst at a cooling rate from 0.1 degree Celsius per minute to 10 degree Celsius per minute and the crystalized carbon-atom arrangement to form a multilayer graphene film on the surface of the carbonizing catalyst,
wherein the gaseous carbon source is supplied at a flow rate from 0.5 standard cubic centimeters per minute ("sccm") to 50 sccm; and
optionally wherein said method further comprises performing a chemical-doping step to chemically dope the multilayer graphene film,
**characterized in that** the weak oxidizing vapor is water or ethanol, provided in an amount of 1% to 10% by volume in an inert gas.

2. The method of claim 1, further comprising separating the multilayer graphene film from the carbonizing catalyst.

3. The method of claim 2, wherein said separating comprises:
forming a protective layer, comprising, for example PMMA, over the multilayer graphene film;
etching away the carbonizing catalyst; and
removing the protective layer from the multilayer graphene film.

4. The method of claim 1, wherein the carbonizing catalyst is disposed in the CVD reaction chamber as a film having a thickness in a range from 300 nm to 1,000 nm or 0.01 mm to 5 mm.

5. The method of claim 1, wherein the carbonizing catalyst is formed from at least one metal selected from the following group of metals: Ni, Cu, Co, Fe, Rh, Pt, Au, Ru and Mo.

6. The method of claim 1, wherein the gaseous carbon source includes at least one gas selected from the following group of gases: carbon monoxide, methane, ethane, ethylene, ethanol, acetylene, propane, propylene, butane, butadiene, pentane, pentene, cyclopentadiene, hexane, cyclohexane, benzene and toluene.

7. The method of claim 1, further comprising flowing hydrogen through the reaction chamber to reduce the carbonizing catalyst.

8. The method of claim 1, wherein the surface of the carbonizing catalyst includes amorphous carbon, and further comprising oxidizing the amorphous carbon while avoiding substantially disrupting the crystalized carbon-atom arrangement on the surface of the carbonizing catalyst.

## Patentansprüche

1. Verfahren zum Wachsenlassen eines Graphenfilms, das Folgendes umfasst:
Anordnen eines Karbonisierungskatalysators, der eine Oberfläche in einer chemischen Dampfphasenabscheidungs(chemical-vapor-deposition - CVD)-Reaktionskammer aufweist, die einen Druck in einem Bereich von 133 mPa (1 mTorr) bis 101 Pa (760 Torr) und eine Temperatur in einem Bereich von 200 °C bis 1.200 °C aufweist;
Strömenlassen einer gasförmigen Kohlenstoffquelle, die Kohlenstoffatome aufweist, und eines schwach oxidierenden Dampfs über die Oberfläche des Karbonisierungskatalysators für eine Zeit in dem Bereich von 1 Minute bis 1 Stunde, wobei dadurch bewirkt wird, dass sich die Kohlenstoffatome aus der Kohlenstoffquelle in eine kristallisierte Kohlenstoffatomanordnung auf der Oberfläche des Karbonisierungskatalysators abscheiden; und
Kühlen des Karbonisierungskatalysators bei einer Kühlrate von 0,1 Grad Celsius pro Minute bis 10 Grad Celsius pro Minute und der kristallisierten Kohlenstoffatomanordnung, um einen mehrschichtigen Graphenfilm auf der Oberfläche des Karbonisierungskatalysators auszubilden,
wobei die gasförmige Kohlenstoffquelle bei einer Strömungsrate von 0,5 Standardkubikzentimeter pro Minute (standard cubic centimeters per minute - "sccm") bis 50 sccm zugeführt wird; und
optional wobei das Verfahren ferner ein Durchführen eines chemischen Dotierungsschritts umfasst, um den mehrschichtigen Graphenfilm chemisch zu dotieren,
**dadurch gekennzeichnet, dass** der schwach oxidierende Dampf Wasser oder Ethanol ist, bereitgestellt in einer Menge von 1 bis 10 Vol.-% in einem Inertgas.

2. Verfahren nach Anspruch 1, das ferner ein Trennen des mehrschichtigen Graphenfilms von dem Karbonisierungskatalysator umfasst.

3. Verfahren nach Anspruch 2, wobei das Trennen Folgendes umfasst:
Ausbilden einer Schutzschicht, die beispielsweise PMMA umfasst, über dem mehrschichtigen Graphenfilm;
Wegätzen des Karbonisierungskatalysators; und
Entfernen der Schutzschicht von dem mehrschichtigen Graphenfilm.

4. Verfahren nach Anspruch 1, wobei der Karbonisierungskatalysator in der CVD-Reaktionskammer als ein Film angeordnet ist, der eine Dicke in einem Bereich von 300 nm bis 1000 nm oder 0,01 mm bis 5 mm aufweist.

5. Verfahren nach Anspruch 1, wobei der Karbonisierungskatalysator aus wenigstens einem Metall ausgebildet ist, das aus der folgenden Gruppe von Metallen ausgewählt ist: Ni, Cu, Co, Fe, Rh, Pt, Au, Ru und Mo.

6. Verfahren nach Anspruch 1, wobei die gasförmige Kohlenstoffquelle wenigstens ein Gas beinhaltet, das aus der folgenden Gruppe von Gasen ausgewählt ist: Kohlenmonoxid, Methan, Ethan, Ethylen, Ethanol, Acetylen, Propan, Propylen, Butan, Butadien, Pentan, Penten, Cyclopentadien, Hexan, Cyclohexan, Benzol und Toluol.

7. Verfahren nach Anspruch 1, das ferner das Strömenlassen von Wasserstoff durch die Reaktionskammer umfasst, um den Karbonisierungskatalysator zu reduzieren.

8. Verfahren nach Anspruch 1, wobei die Oberfläche des Karbonisierungskatalysators amorphen Kohlenstoff beinhaltet, und ferner ein Oxidieren des amorphen Kohlenstoffs umfasst, während im Wesentlichen ein Aufbrechen der kristallisierten Kohlenstoffatomanordnung auf der Oberfläche des Karbonisierungskatalysators vermieden wird.

## Revendications

1. Procédé de croissance d'un film de graphène, comprenant :
la disposition d'un catalyseur de carbonisation ayant une surface dans une chambre de réaction de dépôt chimique en phase vapeur (CVD) ayant une pression dans une plage de 133 mPa (1 mtorr) à 101 Pa (760 torr), et une température dans une plage de 200 °C à 1200 °C ;
l'écoulement d'une source de carbone gazeuse ayant des atomes de carbone, et une faible vapeur oxydante sur la surface du catalyseur de carbonisation pendant une durée comprise entre 1 minute et 1 heure, amenant ainsi le dépôt des atomes de carbone de la source de carbone dans un arrangement d'atomes de carbone cristallisé sur la surface du catalyseur de carbonisation ; et
le refroidissement du catalyseur de carbonisation à une vitesse de refroidissement de 0,1 degré Celsius par minute à 10 degrés Celsius par minute et l'arrangement d'atomes de carbone cristallisé pour former un film de graphène multicouche sur la surface du catalyseur de carbonisation,
la source de carbone gazeuse étant fournie à une vitesse d'écoulement de 0,5 centimètre cube standard par minute ("sccm") à 50 sccm ; et
éventuellement ledit procédé comprenant en outre le fait d'effectuer une étape de dopage chimique pour doper chimiquement le film de graphène multicouche,
**caractérisé en ce que** la vapeur faiblement oxydante est de l'eau ou de l'éthanol prévu à raison de 1 à 10 % en volume dans un gaz inerte.

2. Procédé selon la revendication 1, comprenant en outre la séparation du film de graphène multicouche du catalyseur de carbonisation.

3. Procédé selon la revendication 2, dans lequel ladite séparation comprend :
la formation d'une couche protectrice, comprenant par exemple du PMMA, sur le film de graphène multicouche ;
l'élimination par gravure du catalyseur de carbonisation ; et
le retrait de la couche protectrice du film de graphène multicouche.

4. Procédé selon la revendication 1, dans lequel le catalyseur de carbonisation est disposé dans la chambre de réaction CVD sous la forme d'un film ayant une épaisseur dans une plage de 300 nm à 1000 nm ou de 0,01 mm à 5 mm.

5. Procédé selon la revendication 1, dans lequel le catalyseur de carbonisation est formé d'au moins un métal choisi dans le groupe de métaux suivant : Ni, Cu, Co, Fe, Rh, Pt, Au, Ru et Mo.

6. Procédé selon la revendication 1, dans lequel la source de carbone gazeuse comporte au moins un gaz choisi dans le groupe de gaz suivant : monoxyde de carbone, méthane, éthane, éthylène, éthanol, acétylène, propane, propylène, butane, butadiène, pentane, pentène, cyclopentadiène, hexane, cyclohexane, benzène et toluène.

7. Procédé selon la revendication 1, comprenant en outre l'écoulement d'hydrogène à travers la chambre de réaction pour réduire le catalyseur de carbonisation.

8. Procédé selon la revendication 1, dans lequel la surface du catalyseur de carbonisation comprend du carbone amorphe, et comprenant en outre l'oxydation du carbone amorphe tout en évitant de perturber sensiblement l'arrangement cristallisé des atomes de carbone sur la surface du catalyseur de carbonisation.
